Europäisches Patentamt

European Patent Office

Office européen des brevets

(11) Publication number: **0 133 036**
**B1**

(12) **EUROPEAN PATENT SPECIFICATION**

(45) Date of publication of patent specification: **27.12.90**

(51) Int. Cl.⁵: **H 01 S 3/19, H 01 L 33/00**

(21) Application number: **84305129.3**

(22) Date of filing: **27.07.84**

(54) Semiconductor laser.

(30) Priority: **29.07.83 JP 140756/83**

(43) Date of publication of application:
**13.02.85 Bulletin 85/07**

(45) Publication of the grant of the patent:
**27.12.90 Bulletin 90/52**

(84) Designated Contracting States:
**DE GB NL**

(56) References cited:
**EP-A-0 099 616**
**GB-A-2 057 748**

**IEEE JOURNAL OF QUANTUM ELECTRONICS,
vol. QE-19, no. 6, June 1983, pages 1009-1015,
IEEE, New York, US; S. YAMAMOTO et al.: "680
nm CW operation at room temperature by
AlGaAs double heterojunction lasers"**

(73) Proprietor: **SHARP KABUSHIKI KAISHA
22-22 Nagaike-cho Abeno-ku
Osaka 545 (JP)**

(72) Inventor: **Hayakawa, Toshiro
17-402 Katsuragi-cho
Nara-shi Nara-ken (JP)**
Inventor: **Miyauchi, Nobuyuki
2613-1 Ichinomoto-cho
Tenri-shi Nara-ken (JP)**
Inventor: **Yano, Seiki
126-80 Toyota-cho
Kashihara-shi Nara-ken (JP)**
Inventor: **Suyama, Takahiro
2613-1 Ichinomoto-cho
Tenri-shi Nara-ken (JP)**

(74) Representative: **Wright, Peter David John et al
R.G.C. Jenkins & Co. 26 Caxton Street
London SW1H 0RJ (GB)**

(56) References cited:

**APPLIED PHYSICS LETTERS, vol. 36, no. 8, April 1980, pages 634-636, American Institute of Physics, New York, US; C.-Y. CHEN et al.: "Narrow double-current-confinement channeled-substrate planar laser fabricated by double etching technique"**

**APPLIED PHYSICS LETTERS, vol. 41, no. 9, November 1982, pages 796-798, American Institute of Physics, New York, US; S. YAMAMOTO et al.: "Room-temperature CW operation in the visible spectral range of 680-700 nm by AlGaAs double heterojunction lasers"**

## Description

The present invention relates to a semiconductor laser and, more particularly, to a laser device construction which minimizes the stress applied to an active layer, thereby ensuring stable operation.

A GaAlAs semiconductor laser having a lasing wavelength of about 0.8 µm has been developed, which has an operating period of more than $10^6$ hours at room temperature. The operating life is greatly lengthened by minimizing the occurrence of a dark line or a dark spot, and by minimizing mirror erosion. The occurrence of the dark line or the dark spot is minimized by reducing the defect density in the grown crystal, which is achieved by improvement of the crystal growth techniques or by the reduction of oxygen in the growth system. The mirror erosion is minimized if the mirror surface is coated with a dielectric film made of, for example $Al_2O_3$, $SiO_2$ or $Si_3N_4$.

The above-mentioned semiconductor laser shows stable operation if it is operated as an infrared laser which has a lasing wavelength greater than 0.8 µm. However, the semiconductor laser does not show stable operation nor the long operating lifetime if it is operated as a visible laser which has a lasing wavelength shorter than 0.8 µm.

To enhance the reliability of the GaAlAs semiconductor visible laser, improvements have been proposed in, for example, the present applicant's Japanese Patent Application Nos. 55-166124 and 56-44775, wherein a Te-doped or Se-doped cladding layer is formed through the use of the epitaxial method after the active layer has been formed, whereby the crystal construction of the active layer is greatly enhanced. The thus formed GaAlAs semiconductor laser exhibits the long operating lifetime at a lasing wavelength of around 0.77 µm. However, the operating lifetime suddenly becomes short when the lasing wavelength becomes less than 0.77 µm.

Generally, in the GaAlAs double-heterostructure laser, the lattice constant of the GaAs substrate is similar to the lattice constant of the respective grown layers at the growth temperature, about 800°C. However, the lattice constant of the respective layers and the lattice constant of the GaAs substrate differ from each other at room temperature, because the coefficient of the thermal expansion of $Ga_{1-x}Al_xAs$ varies as the Al mole fraction x varies. The above-mentioned difference between the lattice constants creates a large stress applied to the active layer at room temperature. The thus created stress may shorten the operating life of the semiconductor laser.

To minimize the stress caused by the mounted condition, a construction has been proposed in European Patent Application No. 83302006.8, "Semiconductor Laser" filed on April 8, 1983, by Sharp Kabushiki Kaisha, publication No. EP—A—99616 forming state of the art according to Art. 54(3) EPC, wherein the active layer is separated from the mounted surface by a distance which corresponds to at least 35% of the thickness of the semiconductor laser element, and is separated from the opposing element surface by a distance which corresponds to at least 18% of the element thickness.

However, it would be desirable to provide a stable operation beyond that achieved by controlling only the location of the active layer.

An article in IEEE Journal of Quantum Electronics Vol. QE-19 (1983) June No. 6 pp. 1009 describes a device which seeks to overcome the problem caused by the different coefficients of thermal expansion of the GaAs substrate and the GaAlAs active layer by removing the GaAs substrate on which the device is formed.

According to the invention there is provided a GaAlAs semiconductor laser comprising a substrate layer, the composition of which is given by the formula $Ga_{1-z}Al_zAs$;

a current blocking layer formed on said $Ga_{1-z}Al_zAs$ substrate layer;

a V-shaped groove formed in said current blocking layer;

a first $Ga_{1-y}Al_yAs$ cladding layer formed on said current blocking layer;

A $Ga_{1-x}Al_xAs$ active layer formed on said first $Ga_{1-y}Al_yAs$ cladding layer;

a second $Ga_{1-y}Al_yAs$ cladding layer formed on said $Ga_{1-x}Al_xAs$ active layer; and

a $Ga_{1-w}Al_wAs$ cap layer formed on said second $Ga_{1-y}Al_yAs$ cladding layer,

wherein each of the Al mole fractions w, x, y and z is greater than zero, and wherein the AlAs mole fraction z, x and w of said substrate layer (23), active layer (27) and cap layer (29) satisfy the following relations:

$$z < x, \quad \text{and} \quad w < x.$$

In order that the present invention may be better understood a detailed description of an embodiment thereof will be given, by way of example, with reference to the accompanying drawings wherein:

Figure 1 is a schematic sectional view showing a basic construction of a double-heterostructure semiconductor laser element;

Figure 2 is a graph showing the variation of the stress applied to an active layer of the semiconductor laser element of Figure 1 as the AlAs mole fraction of the active layer changes;

Figure 3 is a schematic sectional view showing a semiconductor laser element mounted on a stem;

Figure 4 is a schematic view showing a semiconductor laser wafer for explaining a calculated stress;

Figure 5 is a graph showing the variation of the stress applied to the active layer of the semiconductor laser element of Figure 1 when the external force and thickness ratio $(t_5, t_1)$ of the cap layer and the substrate change;

Figure 6 is a graph showing the variation of the stress applied to the active layer of the semiconductor laser element of Figure 1 when the external force and the AlAs mole fractions of the substrate and the cap layer change;

Figure 7 is a graph showing the variation of the stress applied to the active layer of the semiconductor laser element of Figure 1 when the AlAs mole fractions of the substrate and the cap layer change while the difference ($\Delta$x) between the AlAs mole fraction of the cladding layer and the active layer is fixed at 0.3, and the external force is not applied to the element;

Figure 8 is a graph showing the variation of the stress applied to the active layer of the semiconductor laser element of Figure 1 when the AlAs mole fractions of the substrate and the cap layer, and the AlAs mole fraction of the cladding layer change, while the external force is not applied to the element;

Figure 9 is a graph showing the variation of the stress applied to the active layer when the thickness of the substrate ($t_1$) changes while the total thickness of the substrate and the cap layer is fixed at 100 µm and the external force is not applied to the element;

Figures 10(a) through 10(D) are sectional views for explaining manufacturing steps of an embodiment of a semiconductor laser of the present invention; and

Figure 11 is a sectional view of another embodiment of a semiconductor laser of the present invention.

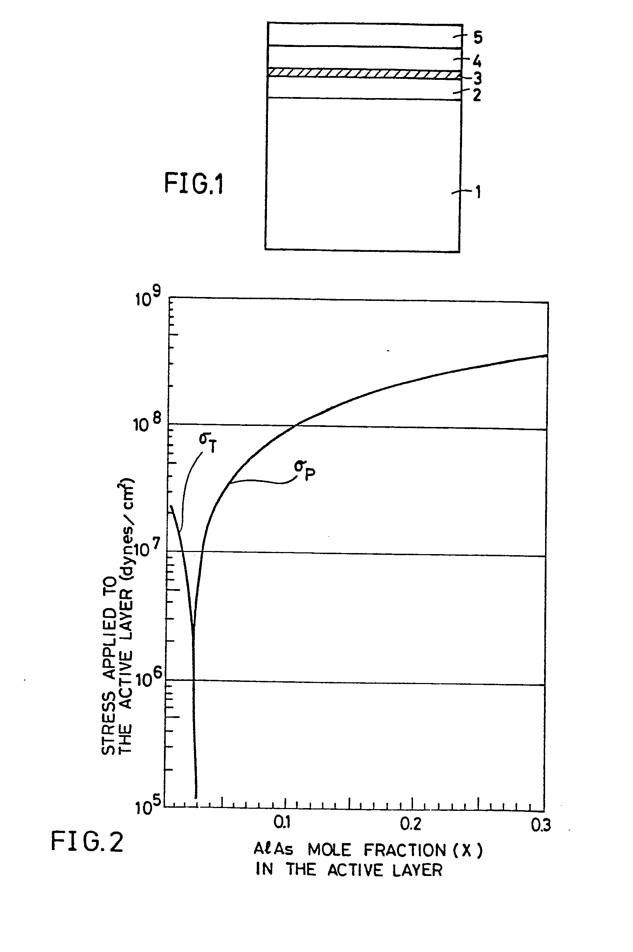

Figure 1 schematically shows a general construction of a double-heterostructure semiconductor laser, which includes a GaAs substrate 1, a $Ga_{1-y}Al_yAs$ cladding layer 2, a $Ga_{1-x}Al_xAs$ active layer 3, a $Ga_{1-y}Al_yAs$ cladding layer 4, and a GaAs cap layer 5. That is, the semiconductor laser generally has a multilayered crystal construction. If the GaAs substrate 1 has a thickness of 100 µm, the active layer 3 has a thickness of 0.1 µm and the cladding layers 2 and 4 and the cap layer 5 each have thicknesses of 1 µm, the stress applied to the active layer 3, when the temperature is reduced from 800°C to 20°C, can be calculated as follows.

Figure 2 shows the stress applied to the active layer 3, as obtained from the calculation, when the AlAs mole fraction "x" of the active layer 3 is varied, while the AlAs mole fraction difference $\Delta$x (=y−x) between the active layer 3 and the cladding layers 2 and 4 is fixed at a value of 0.3. Between x=0 and x=0.02, a tensile stress $\sigma_T$ is applied to the active layer 3. This tensile stress $\sigma_T$ reduces as the AlAs mole fraction "x" increases. Above x=0.02, a compressive stress $\sigma_p$ is applied to the active layer 3, and the compressive stress $\sigma_p$ increases as the AlAs mole fraction "x" increases. The semiconductor laser of Figure 1 exhibits the lasing wavelength of 0.74 µm when the AlAs mole fraction "x"=0.2, at which value a compressive stress in excess of $2 \times 10^8$ dynes/cm$^2$ is applied to the active layer 3 (1 dyne=$10^{-5}$N). The thus applied stress will deteriorate the GaAlAs visible semiconductor laser as reported in IEEE, Journal of Quantum Eletronics, Vol. QE-17, No. 5, pp, 763 (1981).

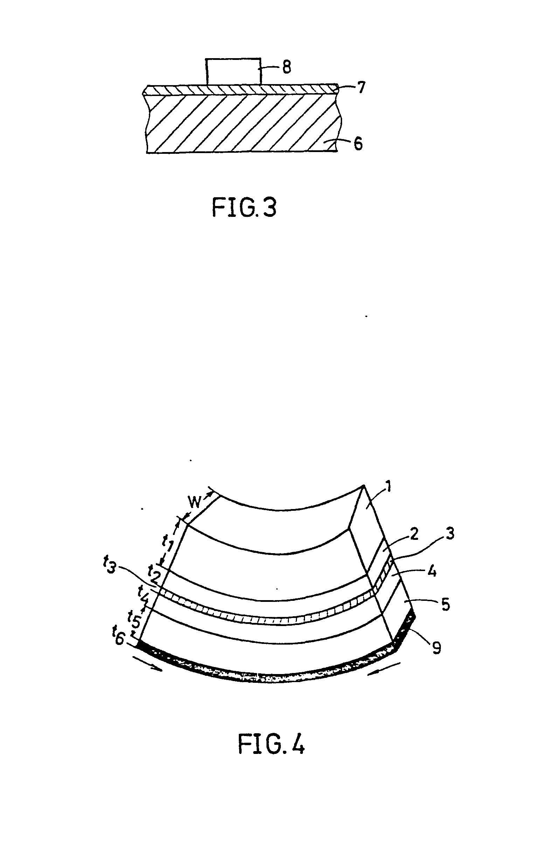

The above-mentioned calculation is not applicable to practical devices, because the semiconductor laser is normally mounted on a Cu heat sink with In solder as shown in Figure 3. That is, a laser element 8 is mounted on a heat sink 6 using a solder 7. The coefficients of thermal expansion of the laser element 8, the heat sink 6 and the solder 7 are different from each other and, therefore, a large stress is applied to the laser element 8 when the device is cooled from the mounting temperature to room temperature.

If a Cu heat sink of 1 mm thickness is employed, a compressive external force of about $10^7$ dynes/cm is applied to the laser element 8 when the temperature reduces by about 150°C, due to the difference of the Cu coefficient of thermal expansion ($1.7 \times 10^{-5}$) and the GaAs coefficient of thermal expansion ($6.9 \times 10^{-6}$). When In solder is interposed between the laser element and the Cu heat sink, the compressive force applied to the laser element is reduced to about $10^6$ dynes/cm due to plastic deformation in the In solder.

When the stress applied to the laser element, which is mounted on the Cu heat sink with the In solder, is measured through the photo-elastic measurement technique, it is observed that the stress becomes small as the distance from the mounted surface increases. Furthermore, the stress becomes large as the distance from the surface opposite to the mounted surface becomes small. That is, the compressive stress is applied from the heat sink to the laser element at the mounted surface, and the tensile stress is applied to the surface opposite the mounted surface due to the deformation created in the laser element. The stress caused by the mounted position is greater than the stress caused by the laser element itself.

A laser construction has been proposed in application EP—A—99616, wherein the active layer is located in a device at a position where the stress caused by the mounted condition is minimized. More specifically, in EP—A—99616, a laser device is proposed, wherein the active layer is separated from the mounted surface by a distance which corresponds to at least 35% of the thickness of the laser element, and is separated from the opposing surface by at least 18% of the element thickness.

The present invention further reduces the stress applied to the active layer by providing a substrate and cap layer having a coefficient of thermal expansion similar to the cladding layers, thereby ensuring stable operation at lasing wavelengths below 0.77 µm.

The stress applied to the active layer can be calculated as follows. The following calculation is based on a semiconductor laser similar to that shown in Figure 4.

The semiconductor laser element of Figure 1 is mounted on a base layer 9 functioning as the heat sink and the solder. In the example of Figure 4, the semiconductor laser element is mounted on the base layer 9 in a fashion that the cap layer 5 contacts the base layer 9. However, a similar result is obtained even when the semiconductor laser element is mounted on the base layer 9 such that the substrate 1 is in contact with the base layer 9. The calculation is based on the assumption that the strain in the semiconductor laser element is caused by the difference between the coefficients of thermal expansion of the respective layers when the temperature is reduced from the growth temperature 800°C to room temperature 20°C, namely, by 780°C. Further, the shrinkage of the base layer 9 changes to vary the external force applied to the semiconductor laser element.

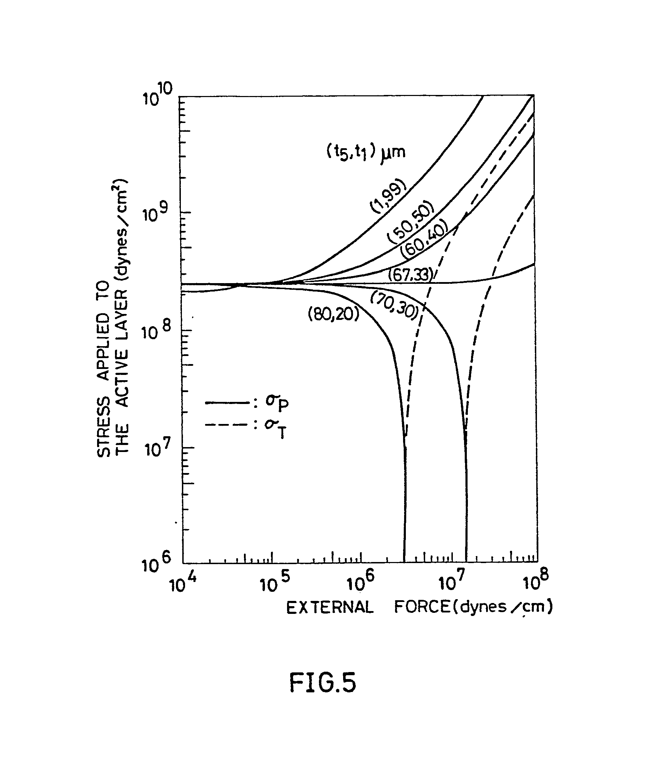

Figure 5 shows the result of the calculation when the semiconductor laser element has a GaAs substrate 1 and a GaAs cap layer 5, and exhibits a lasing wavelength of about 750 nm. More specifically, Figure 5 shows the stress applied to the active layer 3, depending on the external force, when the AlAs mole fractions of the substrate 1 and the cap layer 5 are "0", the AlAs mole fraction (y) of the cladding layers 2 and 4 is "0.5", and the AlAs mole fraction (x) of the active layer 3 is "0.2". The $Ga_{0.5}Al_{0.5}As$ cladding layer 2 has a thickness of 1 μm, the $Ga_{0.8}Al_{0.2}As$ active layer 3 has a thickness of 0.1 μm, and the $Ga_{0.5}Al_{0.5}As$ cladding layer 4 has a thickness of 1 μm. Further, the thickness of the GaAs substrate 1 is varied while the total thickness of the GaAs substrate 1 and the GaAs cap layer 5 is maintained at 100 μm.

It will be clear from Figure 5 that the external force does not affect the active layer 3 if the thickness ratio of the cap layer 5 and the substrate 1 is selected at 67:33. As discussed in application EP—A—99616, in the case of the external force not being very strong, the stress applied to the active layer 3 is considerably reduced when the active layer 3 is separated from the mounted surface by at least 35% of the laser element thickness, and is separated from the opposing surface by at least 18% of the laser element thickness.

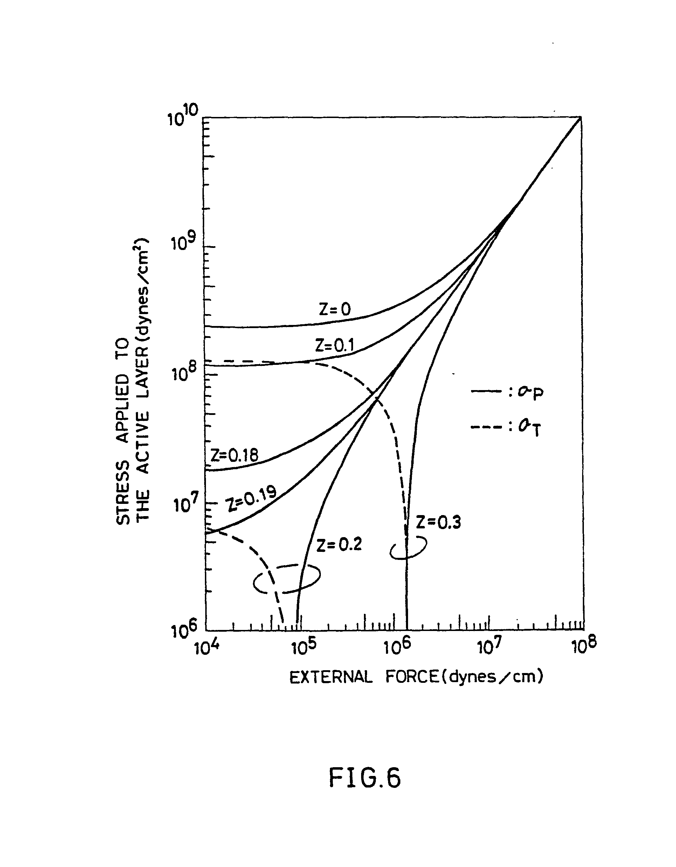

The present invention reduces the stress applied to the active layer 3 by employing a GaAlAs substrate and a GaAlAs cap layer so as to minimize the difference between the coefficients of the thermal expansion of the double-heterostructure layers and the substrate or the cap layer. Figure 6 shows the result of the calculation of the stress applied to the $Ga_{0.8}Al_{0.2}As$ active layer 3 of Figure 4 when a $Ga_{1-z}Al_zAs$ substrate 1 and a $Ga_{1-z}Al_zAs$ cap layer 5 each have a thickness of 50 μm, respectively. The remaining layers have the same construction as those discussed with reference to Figure 5. Figure 6 shows the effect of the external force when the AlAs mole fraction (z) of the $Ga_{1-z}Al_zAs$ substrate 1 and the $Ga_{1-z}Al_zAs$ cap layer 5 is changed. It will be clear from Figure 6 that the compressive stress applied to the active layer 3 reduces as the AlA mole fraction (z) increases. Further, the tensile stress applied to the active layer 3 increases as the AlAs mole fraction (z) increases when the external force is considerably small.

The In solder disposed between the Cu heat sink and the semiconductor laser element functions to reduce the stress applied to the laser element because the melting point of In is relatively low, 155°C, and the In solder endures plastic deformation in addition to elastic deformation when the device is cooled from the melting point to room temperature. When In solder of several microns thickness is disposed between the 1 mm thick Cu heat sink and the laser element, the external force applied to the laser element is supposed to be $10^6$—$10^7$ dynes/cm. It will be clear from Figure 6 that, when such an external force is applied to the laser element, the compressive stress applied to the active layer 3 is reduced when the AlAs mole fraction (z) is increased at least to 0.2. However, the tensile stress is applied to the active layer 3 when the AlAs mole fraction (z) is 0.2 and the external force is considerably small. When the AlAs mole fraction (z) is 0.03, the tensile stress is applied to the active layer 3 even when the external force is $10^6$ dynes/cm. The tensile stress will increase the defect density in the crystal and, therefore, such a high value for the AlAs mole fraction (z) should not be selected.

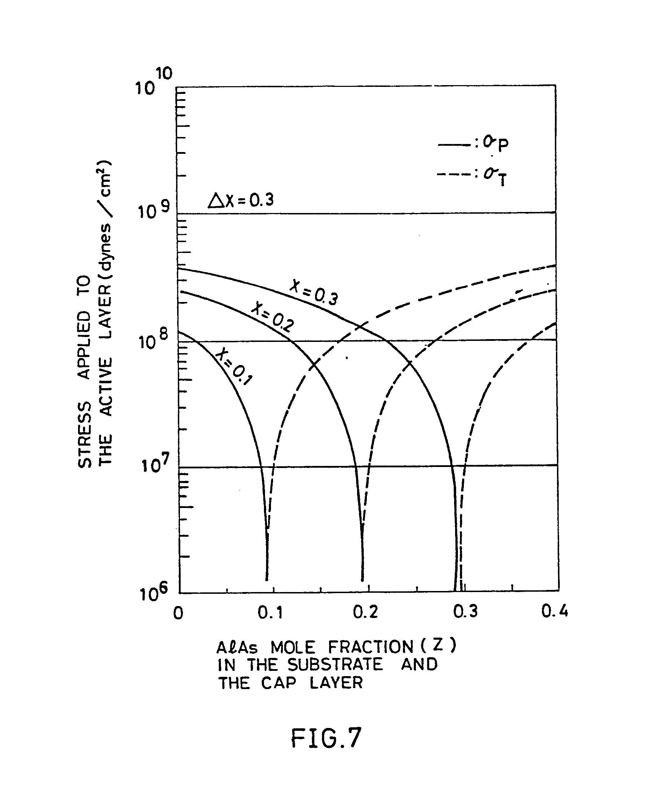

Figure 7 shows the stress applied to the active layer 3 when no external force is applied to the laser element, and the AlAs mole fraction (z) of the substrate and the cap layer is changed. Figure 7 is obtained by the calculation when the difference (Δx) between the AlAs mole fraction (y) of the cladding layer and the AlAs mole fraction (x) of the active layer is fixed at 0.3. Figure 7 shows three cases having a AlAs mole fraction (x) of 0.1, 0.2 and 0.3. The semiconductor laser element has a substrate and cap layer each of 50 μm thickness, cladding layers each 1 μm thick, and an active layer of 0.1 μm thickness. It will be clear from Figure 7 that, when no external force is applied to the semiconductor laser element, the compressive stress applied to the active layer 3 decreases as the AlAs mole fraction (z) of the substrate and the cap layer increases toward the AlAs mole fraction (x) of the active layer. If the AlAs mole fraction (z) of the substrate and the cap layer exceeds the AlAs mole fraction (x) of the active layer, the tensile stress applied to the active layer 3 increases as the AlAs mole fraction (z) of the substrate and the cap layer increases.

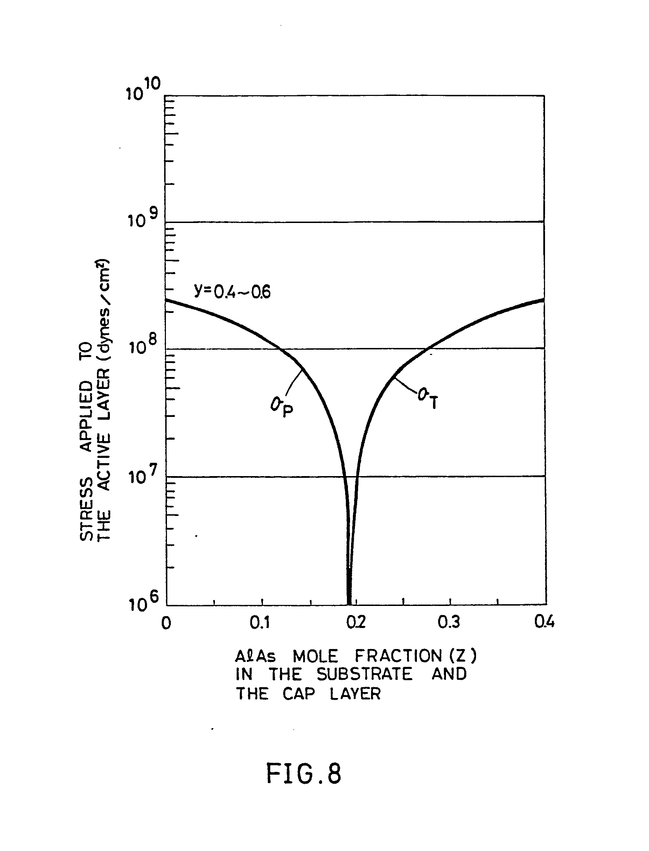

The above-mentioned variation of the stress applied to the active layer 3 is not affected by the variation of the AlAs mole fraction (y) of the cladding layers 2 and 4. Figure 8 shows the stress applied to the $Ga_{0.8}Al_{0.2}As$ active layer 3 when the AlAs mole fraction (z) of the substrate 1 and the cap layer 5, and the AlAs mole fraction (y) of the cladding layers 2 and 4 are changed.

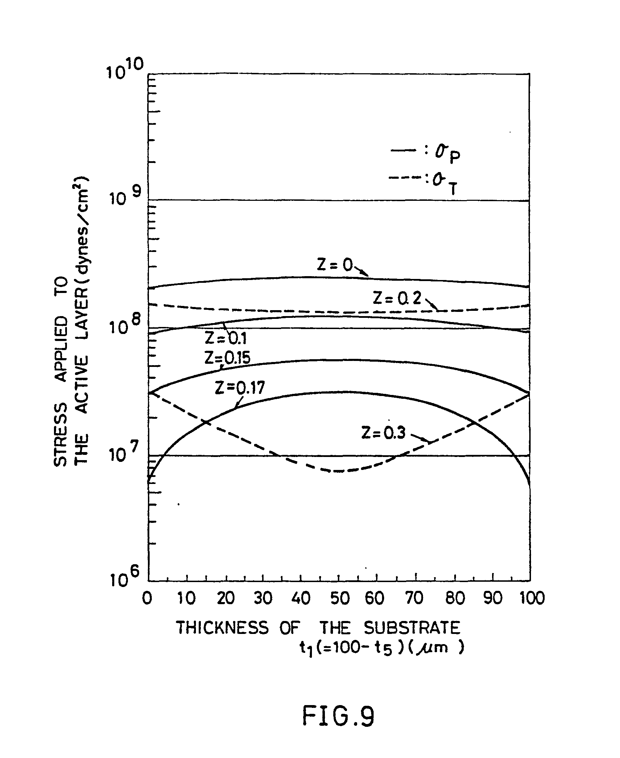

Figure 9 shows the stress applied to the active layer 3 when the thickness of the substrate is changed while the total thickness of the substrate 1 and the cap layer 5 is fixed at 100 μm. Figure 9 shows various cases when the AlAs mole fraction (z) of the substrate 1 and the cap layer 5 is changed, while the AlAs mole fraction (x) of the active layer 3 is fixed at 0.2 and the AlAs mole fraction (y) of the cladding layers 2 and 4 is fixed at 0.5.

It will be clear from the foregoing description that the effect caused by the external force is significantly reduced when the active layer 3 is separated from the mounted surface by more than 35% of the thickness of the semiconductor laser element, and the active layer 3 is separated from the opposing surface by more than 18% of the thickness of the semiconductor laser element. The compressive stress applied to the active layer 3 is further reduced when the AlAs mole fraction (z) of the substrate 1 and the cap layer 5 is selected slightly smaller than the AlAs mole fraction (x) of the active layer 3.

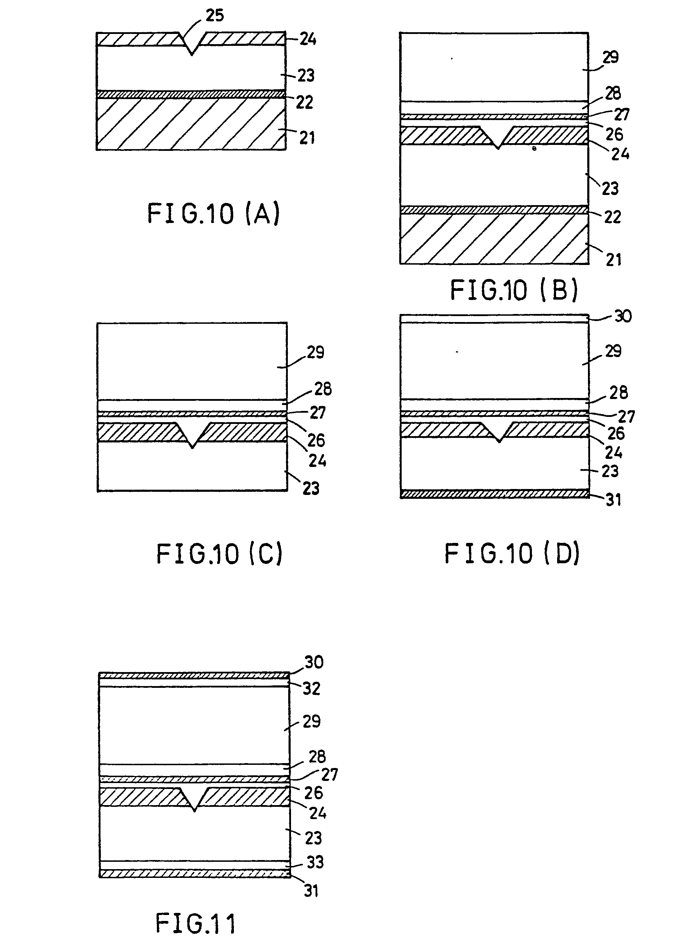

Figures 10(A) through 10(D) show steps for manufacturing an embodiment of the semiconductor laser element of the present invention.

As shown in Figure 10(A), on a GaAs substrate 21, a GaAlAs etching stop layer 22 (thickness 0.5 μm) having an AlAs mole fraction higher than 0,5, a p-$Ga_{0.8}Al_{0.2}As$ substrate 23 (thickness 60 μm), and an n-GaAs current blocking layer 24 (thickness 0.8 μm) are sequentially formed using the liquid-phase growth method. Then, a V-shaped groove 25 is formed in the current blocking layer 24 using the etching method. The V-shaped groove 25 reaches the p-$Ga_{0.8}Al_{0.2}As$ substrate 23 to define a current path so that a semiconductor laser having a V-shaped groove for current confinement is formed.

On the thus formed current blocking layer 24, as shown in Figure 10(B), a p-$Ga_{0.5}Al_{0.5}As$ cladding layer 26 (thickness 0.15 μm at the flat portion), a p-$Ga_{0.8}Al_{0.2}As$ active layer 27 (thickness 0.1 μm), an n-$Ga_{0.5}Al_{0.5}As$ cladding layer 28 (thickness 1 μm), and n-$Ga_{0.8}Al_{0.2}As$ cap layer 29 (thickness 40 μm) are formed through the sequential liquid-phase epitaxial growth method.

Thereafter, the GaAs substrate 21 is removed by a sulphuric acid system etchant. The etching operation is blocked by the etching stop layer 22 which has a high AlAs mole fraction. Then, the etching stop layer 22 is removed by hydrogen fluoride (HF) so as to obtain a semiconductor laser wafer as shown in Figure 10(C).

A p-electrode 31 is formed on the p-$Ga_{0.8}Al_{0.2}As$ substrate layer 23, and an n-electrode 30 is formed on the n-$Ga_{0.8}Al_{0.2}As$ cap layer 29 as shown in Figure 10(D) using the sputter method.

Each layer in the semiconductor laser element of the present embodiment is formed through the annealing method in association with the liquid-phase epitaxial growth method. Accordingly, the AlAs mole fraction the p-GaAlAs substrate layer 23 and the n-GaAlAs cap layer 29, which have large thicknesses, decreases as the layer gradually grows. Even though the AlAs mole fraction (z) of the substrate layer 23 and the cap layer 29 is set to 0.2, identical with the AlAs mole fraction of the active layer 27, at the initial stage of the growing process, the mean value of the AlAs mole fraction (z) of each layer becomes considerably less than the AlAs mole fraction (x) of the active layer 27 when the layers are formed to the desired thickness. Therefore, a compressive stress is applied to the active layer even when the external force is not applied to the semiconductor laser element.

Even when the AlAs mole fraction (z) of the p-GaAlAs substrate layer 23 and the n-GaAlAs cap layer 29 is set to a value relatively greater than the AlAs mole fraction (x) of the p-GaAlAs active layer 27 at the initial stage of the liquid-phase epitaxial growth process, the mean value of the AlAs mole fraction (z) of the p-GaAlAs substrate layer 23 and the n-GaAlAs cap layer 29 becomes less than the mole fraction (x) of the p-GaAlAs active layer 27 when the layers are completely formed. Thus, the tensile stress will not be applied to the active layer. However, if the AlAs mole fraction (z) is selected at a considerably higher value, it becomes difficult to form the ohmic contacts on the p-GaAlAs substrate layer 23 and the n-GaAlAs cap layer 29.

Figure 11 shows another embodiment of the semiconductor laser element of the present invention suited for ensuring the formation of the ohmic contact electrodes on the substrate layer 23 and the cap layer 29. A p-GaAs layer 33 (thickness 0.5 μm) is formed on the etching stop layer 22 (see Figure 10(A)) and, then, the p-GaAlAs substrate layer 23 is formed on the p-GaAs layer 33. When the etching stop layer 22 is removed, the p-electrode 31 is easily formed on the p-GaAs layer 33. In the same manner, an n-GaAs layer 32 (thickness 0.5 μm) is formedon the n-GaAlAs cap layer 29 (see Figure 10(B)). The n-electrode 30 is easily formed on the n-GaAs layer 32.

The invention being thus described, it will be obvious that the same may be varied in many ways. Such variations are not to be regarded as a departure from the invention. There are described above novel features which the skilled man will appreciate give rise to advantages. These are each aspects of the invention as claimed.

## Claims

1. A GaAlAs semiconductor laser comprising:

a substrate layer (23), the composition of which is given by the formula $Ga_{1-z}Al_zAs$;

a current blocking layer (24) formed on said $Ga_{1-z}Al_zAs$ substrate layer;

a V-shaped groove formed in said current blocking layer;

a first $Ga_{1-y}Al_yAs$ cladding layer (26) formed on said current blocking layer;

a $Ga_{1-x}Al_xAs$ active layer (27) formed on said first $Ga_{1-y}Al_yAs$ cladding layer;

a second $Ga_{1-y}Al_yAs$ cladding layer (28) formed on said $Ga_{1-x}Al_xAs$ active layer; and

a $Ga_{1-w}Al_wAs$ cap layer (29) formed on said second $Ga_{1-y}Al_yAs$ cladding layer,

wherein each of the Al mole fractions w, x, y and z is greater than zero, and wherein the AlAs mole fraction z, x and w of said substrate layer (23), active layer (27) and cap layer (29) satisfy the following relations:

z<x, and   w<x.

2. The GaAlAs semiconductor laser of claim 1, wherein said $Ga_{1-z}Al_zAs$ substrate layer (23) has a thickness of about 60 µm, said $Ga_{1-w}Al_wAs$ cap layer (29) has a thickness of about 40 µm.

3. The GaAlAs semiconductor laser of claim 1, further comprising:

a first electrode (30) formed on the surface of said $Ga_{1-w}Al_wAs$ cap layer (29);

a first GaAs layer (32) disposed between said surface of said $Ga_{1-w}Al_wAs$ cap layer (29) and said first electrode (30);

a second electrode (31) disposed on the surface of said $Ga_{1-z}Al_zAs$ substrate layer (23); and

a second GaAs layer (33) disposed between said surface of said $Ga_{1-z}Al_zAs$ substrate layer (23) and said second electrode (31).

4. The GaAlAs semiconductor laser of claim 3, wherein the AlAs mole fraction z and w of the substrate layer (23) and the cap layer (29) has the same value, and the AlAs mole fraction x of the active layer (27) is 0.2.

## Patentansprüche

1. GaAlAs-Halbleiterlaser mit

—einer Substratschicht (23), deren Zusammensetzung durch die Formel $Ga_{1-z}Al_zAs$ gegeben ist;

—einer Stromsperrschicht (23), die auf der $Ga_{1-z}Al_zAs$-Substratschicht ausgebildet ist;

—einem V-förmigen Graben, der in der Stromsperrschicht ausgebildet ist;

—einer ersten Abdeckschicht (26), die aus $Ga_{1-y}Al_yAs$ auf der Stromsperrschicht ausgebildet ist;

—einer aktiven Schicht (27), die aus $Ga_{1-x}Al_xAs$ auf der ersten Abdeckschicht aus $Ga_{1-y}Al_yAs$ ausgebildet ist;

—einer zweiten Abdeckschicht (28), die aus $Ga_{1-y}Al_yAs$ auf der aktiven Schicht aus $Ga_{1-x}Al_xAs$ ausgebildet ist, und

—einer Deckschicht (29), die aus $Ga_{1-w}Al_wAs$ auf der zweiten Abdeckschicht aus $Ga_{1-y}Al_yAs$ ausgebildet ist,

—wobei jedes der Al-Molverhältnisse w, x, y und z größer Null ist, und wobei die AlAs-Molverhältnisse z, x und w der Substratschicht (23), der aktiven Schicht (27) und der Deckschicht (29) den folgenden Beziehungen genügen:

z<x   und   w<x.

2. GaAlAs-Halbleiterlaser nach Anspruch 1, bei dem die Substratschicht (23) aus $Ga_{1-z}Al_zAs$ eine Dicke von etwa 60 µm und die Deckschicht (29) aus $Ga_{1-w}Al_wAs$ eine Dicke von etwa 40 µm aufweist.

3. GaAlAs-Halbleiterlaser nach Anspruch 1, der außerdem aufweist:

—eine erste Elektrode (30), die auf der Oberfläche der Deckschicht (29) aus $Ga_{1-w}Al_wAs$ ausgebildet ist;

—eine ersten GaAs-Schicht (32), die zwischen der Oberfläche der Deckschicht (29) aus $Ga_{1-w}Al_wAs$ und der ersten Elektrode (30) angeordnet ist;

—eine zweite Elektrode (31), die auf der Oberfläche der Substratschicht (23) aus $Ga_{1-z}Al_zAs$ angeordnet ist, und

—eine zweite GaAs-Schicht (33), die zwischen der Oberfläche der Substratschicht (23) aus $Ga_{1-z}Al_zAs$ und der zweiten Elektrode (31) angeordnet ist.

4. GaAlAs-Halbleiterlaser nach Anspruch 3, bei dem die AlAs-Molverhältnisse z und w der Substratschicht (23) und der Deckschicht (29) denselben Wert aufweisen und das AlAs-Molverhältnis x der aktiven Schicht (27) 0,2 ist.

## Revendications

1. Laser à semi-conducteur au GaAlAs comprenant:

une couche-substrat (23) dont la composition est donnée par la formule $Ga_{1-x}Al_xAs$;

une couche barrière de courant (24), formée sur ladite couche-substrat en $Ga_{1-x}Al_xAs$;

une rainure en forme de V ménagée dans ladite couche barrière de courant;

une première couche de revêtement (26) en $Ga_{1-y}Al_yAs$, formée sur ladite couche barrière de courant;

une couche active (27) en $Ga_{1-x}Al_xAs$, formée sur ladite première couche de revêtement en $Ga_{1-y}Al_yAs$;

une seconde couche de revêtement (28) en $Ga_{1-y}Al_yAs$, formée sur ladite couche active en $Ga_{1-x}Al_xAs$; et

une couche d'encapsulage (29) en $Ga_{1-w}Al_wAs$, formée sur ladite seconde couche de revêtement en $Ga_{1-y}Al_yAs$, dans lequel chacune des fractions molaires w, x, y et z de Al est supérieure à zéro, et dans lequel les fractions molaires z, x et w de AlAs dans ladite couche-substrat (23), la couche active (27) et la couche d'encapsulage (29) satisfont les relations suivantes:

z<x,   et   w<x.

2. Laser à semi-conducteur au GaAlAs selon la revendication 1, dans lequel ladite couche-substrat (23) en $Ga_{1-x}Al_xAs$ présente une épaisseur d'environ 60 µm, ladite couche d'encapsulage (29) en $Ga_{1-w}Al_wAs$ présentant une épaisseur d'environ 40 µm.

3. Laser à semi-conducteur en GaAlAs selon la revendication 1 comprenant en outre:

une première électrode (30) formée sur la surface de ladite couche d'encapsulage (29) en $Ga_{1-w}Al_wAs$;

une première couche en GaAs (32) disposée entre ladite surface de ladite couche d'encapsulage (29) en $Ga_{1-w}Al_wAs$ et ladite première électrode (30);

une second électrode (31) disposée sur la surface de ladite couche-substrat (23) en $Ga_{1-x}Al_xAs$; et

une seconde couche en GaAs (33) disposée entre ladite surface de ladite couche-substrat (23) en $Ga_{1-x}Al_xAs$ et ladite seconde électrode (31).

4. Laser à semi-conducteur au GaAlAs selon la

revendication 3, dans lequel les fractions molaires z et w de AlAs dans la couche-substrat (23) et la couche d'encapsulage (29) ont la même valeur, et la fraction molaire x de AlAs dans la couche active (27) est de 0,2.

FIG.1

FIG.2

AlAs MOLE FRACTION (X)
IN THE ACTIVE LAYER

1

FIG. 3

FIG. 4

FIG.5

3

FIG.6

FIG.7

FIG.8

FIG.9

FIG.10 (A)

FIG.10 (B)

FIG.10 (C)

FIG.10 (D)

FIG.11

8